# EUROPEAN PATENT SPECIFICATION

(11) **EP 1 350 588 B1**
(45) Date of publication and mention of the grant of the patent: **02.08.2006**
(21) Application number: 03251732.8
(22) Date of filing: 20.03.2003
(51) Int. Cl.: B23K 1/008, H05K 13/04, H01L 23/15

(54) **Method of manufacturing semiconductor device**
Verfahren zur Herstellung einer Halbleitervorrichtung
Méthode de fabrication d'un dispositif à semiconducteur

(30) Priority: 29.03.2002 JP 2002094650
(43) Date of publication of application: 08.10.2003
(73) Proprietor: FUJI ELECTRIC CO., LTD., Kawasaki-shi, Kanagawa 210-0856 (JP)
(72) Inventor: Morozumi, Akira, Kawasaki-ku, Kawasaki 210-0856 (JP); Yamada, Katsumi, Kawasaki-ku, Kawasaki 210-0856 (JP); Miyasaka, Tadashi, Kawasaki-ku, Kawasaki 210-0856 (JP); Mochizuki, Eiji, Kawasaki-ku, Kawasaki 210-0856 (JP)
(74) Representative: Haley, Stephen

(56) References cited:
- US-A- 4 645 116
- US-A- 4 860 942
- MIZUISHI K ET AL: "Fluxless and substantially voidless soldering for semiconductor chips" PROC. ELECTRON COMPONENTS CONF. IEEE, 9 May 1988 (1988-05-09), pages 330-334, XP010077236 NEW YORK, USA
- ONUKI J ET AL: "A NEW VOID FREE SOLDERING PROCESS IN LARGE-AREA, HIGH POWRE IGBT MODULES" 12TH. INTERNATIONAL SYMPOSIUM ON POWER SEMICONDUCTOR DEVICES AND IC S.ISPSD 2000. PROCEEDINGS. TOULOUSE, FRANCE, MAY 22 - 25, 2000, INTERNATIONAL SYMPOSIUM ON POWER SEMICONDUCTOR DEVICES & IC'S, NEW YORK, NY : IEEE, US, 22 May 2000 (2000-05-22), pages 367-370, XP000987886 ISBN: 0-7803-6269-1
- BARNES P W: "Void free die attachment for multichip modules using solder alloys" 1998, NEW YORK, NY, USA, IEEE, USA, 15 April 1998 (1998-04-15), pages 435-440, XP002290120 ISBN: 0-7803-4850-8

## Description

The present invention relates to a method of manufacturing a semiconductor device, and more particularly to a method of manufacturing a power semiconductor device represented by a power module. The power module has an arrangement in which an element, having a silicon chip or the like soldered on to an insulator substrate, such as a ceramic substrate having a metal circuit sheet, is soldered on to a metal base.

The manufacture of power semiconductor devices has previously been carried out, in general, by one of the following three methods. In the first method, preliminary soldering is first carried out using a continuous furnace (a tunnel furnace) in a reduced pressure atmosphere to provide solder on electrodes on a bottom face of a silicon chip. Subsequent to this, the silicon chip is soldered on to an insulator substrate with the solder there between. After this, wire bonding is carried out. The resulting element is then soldered, in the reduced pressure atmosphere, on to a metal base made of copper using a flux.

In the second method, a silicon chip and an insulator substrate are soldered together in a continuous furnace with a reduced pressure atmosphere. After this, wire bonding is carried out. The resulting element is then soldered on to a metal base using the continuous furnace in the reduced atmosphere.

In the third method, by using a reduced pressure furnace in an inert atmosphere, a silicon chip, an insulator substrate and a metal base are soldered together with flux cored solder. After this, wire bonding is carried out.

Incidentally, in a power semiconductor device such as a power module, a large current flowing therein causes a significantly large amount of heat to be generated in the silicon chip. This can be as much as several tens to several thousands of watts. An excellent heat dissipation characteristic is therefore required in the power semiconductor device. However, the presence of voids in a solder bonded layer between the silicon chip and the insulator substrate, or in a solder bonded layer between the insulator substrate and the metal base, prevents heat dissipation. This brings about significant degradation in the heat dissipation characteristics of the semiconductor device, thereby damaging the device. It is therefore important that as few voids as possible are present in the solder bonded layer.

One reason that voids are generated in the solder bonded layer is that a gas, such as carbon dioxide gas, dissolved in a solder material can remain in the solder when the solder melts. Voids can also be created during soldering when materials adsorbed on to surfaces of the solder or the components to be bonded, or tin oxide, copper oxide on the patterned copper surface, nickel oxide on the patterned metal surface or plating thereon, or the like are reduced and H₂O produced thereby is gasified to create voids. Furthermore, voids may also be caused by gasses generated by vaporization of a flux when the flux itself remains in the solder bonded layer.

Therefore, in order to reduce the creation of voids in the solder bonded layer, countermeasures have generally been taken in order to prevent the surfaces of the components to be bonded from being oxidized, and to keep the surfaces clean. Solder materials without dissolved gas or solder materials with good wettability may also be used, and soldering may be carried out in a depressurized atmosphere. Moreover, countermeasures have been taken so as to optimize the soldering profile and to control deformation of the components to be bonded.

There have been a number of proposals concerning the method of soldering. For example, a method is known in which an atmosphere containing a gas having a higher thermal conductivity than that of the air inside a sealed vessel is formed, and the pressure of the atmosphere is reduced prior to heating and melting the solder. Before the solder is solidified, the pressure of the atmosphere is raised to be higher than the pressure before melting the solder (JP-A-11-154785). In this method, by compressing the voids, the volume thereof is reduced.

In addition, a method is known in which solder is provided on a substrate and electronic parts are temporarily mounted on the solder sections before the solder is heated and melted in a vacuum, in orderto solder the electronic parts (JP-A-7-79071). In the method, no reduction gas such as hydrogen gas is used.

Moreover, there is known a method of manufacturing a semiconductor device including the step of carrying out solder bonding of an insulator substrate having a conductor layer on a metal base, and the step of mounting a semiconductor chip on the insulator substrate, wherein the step of carrying out solder bonding includes the step of melting solder under atmospheric pressure, the step of reducing the pressure of the melted solder, the step of returning the pressure of the melted solder to atmospheric pressure, and the step of solidifying the melted solder (JP-A-11-186331). The method is one in which a vacuum operation is applied to solder bonding using a flux. No reference is made in the publication to hydrogen or a reduced pressure atmosphere.

Furthermore, a method is known in which, when soldering a bare chip or the like and a heat spreader, the heat spreader, to which the bare chip is soldered beforehand, is put in a vacuum heat treatment furnace. Heating is then carried out while evacuating the inside of the furnace to melt the soldered part again (JP-A-5-291314). The method is a soldering method using flux, and no reference is made in the publication to hydrogen or a reduced pressure atmosphere.

In addition, a method of carrying out solder bonding by using a soldering apparatus is known. The soldering apparatus includes a processing vessel, means for controlling the atmosphere and pressure in the processing vessel by producing a low oxygen concentration atmosphere through evacuation and introducing a high purity gas, and heating means provided in the processing vessel. With the use of the soldering apparatus, the solder bonding is carried out by heating a circuit board with the heating means, and by controlling the pressure of the atmosphere in the processing vessel (JP-A-8-242069).

However, the following problems are present in the first to third methods of those explained above. In the first method, the silicon chip is mounted on a jig, and both preliminary soldering and further soldering of the silicon chip to the insulator substrate are carried out. This repetitive soldering increases the probability of damaging the silicon chips, and is liable to cause failure in their electrical characteristics.

In the first and second methods, a bimetallic effect due to differences in the coefficients of thermal expansion between the silicon chip, the metal circuit board, and the ceramic, may produce warping in the insulator substrate after soldering. The produced warping creates nonuniform stress in the silicon chip during wire bonding. The resulting damage can cause failure in the electrical characteristics of the silicon chips.

In the first and third methods, cleaning must be carried out to remove flux after the soldering is finished. However, contaminants such as residues from cleaning which adhere to the surface of the silicon chip can also causes failure in electrical characteristics, such as degradation of the breakdown voltage. Particularly, in the third method, since the wire bonding is carried out after cleaning, adhered flux residue or residue from cleaning prevents wire bonding sections from forming strong bonds, thus reducing reliability.

In the first and third methods, a continuous soldering furnace having a total length close to 10m is used. When the furnace is in operation, a continuous flow of a gas necessary for soldering, such as hydrogen or nitrogen, must always be provided. Moreover, differences in heat capacity among materials fed into the furnace necessitates control of the furnace temperature whenever a material is fed in. At the start of the furnace operation, it takes a great deal of time for the temperature and atmosphere inside the furnace to become uniform. This results in large operational costs.

Moreover, in the first to third methods explained above, the following problem concerning heat dissipation also arises. In the first and second methods, the soldering is carried out under atmospheric pressure (normal pressure) using the continuous furnace. This causes escape paths of voids in the solder, produced while the solder is melting, to be cut off by the viscous solder or the components to be bonded. Therefore, the voids are liable to be left in solder bonded layers. Thus, as explained above, it is necessary to use solder material with less dissolved gas, or to store or pack the solder materials or components to be bonded so that their surfaces do not become oxidized. This, however, brings about a rise in the cost of the materials. Moreover, precise control of the oxygen concentration, the dew point, and the temperature profile in the soldering furnace is required, which results in a significant increase in the operational costs of the soldering furnace.

Furthermore, in the third method, insufficient depressurization causes traces of removed fluxes, i.e. traces of travelled fluxes, to be left as voids in the solder bonded layer. In addition, the method takes so much time to remove all of the fluxes by depressurization that a decrease in productivity, in the case of a batch furnace, results. Moreover, rosin, a main ingredient of the flux, can adhere to the inside of the depressurized chamber or can be deposited on to piping. This necessitates frequent cleaning of the inside of the apparatus, with the result that maintaining and controlling the apparatus becomes extremely expensive. Further, soldering carried out at 300°C or more causes sticking of scorched flux. Therefore, no soldering can be carried out at 300°C or more

US-A-4860942 discloses a method for soldering void-free joints. IEEE document no. 0569-5503/88/0000-0330 (Mizuishi, K. et al.) (1988-05-09) discloses fluxless and substantially voidless soldering for semiconductor chips. US-A-4645116 discloses fluxless bonding of microelectronic chips.

The present invention has been devised in view of the above problems, described above.

Accordingly, the invention resides in a method of manufacturing a semiconductor device, comprising the steps of:
feeding a laminate into a reduced pressure furnace, the laminate including at least two components to be bonded with a solder sheet therebetween; evacuating the inside of the reduced pressure furnace in a depressurisation step; in a first reduction step, introducing hydrogen into the reduced pressure furnace and then heating the inside of the reduced pressure furnace to a bonding temperature to melt the solder sheet whilst maintaining the composition and pressure of the atmosphere therein;
in a void removing step, removing the voids in the liquefied solder by evacuating the reduced pressure furnace, while keeping the temperature therein at the bonding temperature;
in a second reduction step, introducing hydrogen into the reduced pressure furnace while keeping the temperature therein at the bonding temperature, and then maintaining the pressure and temperature for a specified length of time; and
rapidly cooling the laminate while maintaining the composition and pressure of the atmosphere inside the reduced pressure furnace, characterised by: the step of introducing hydrogen into the reduced pressure furnace, in both of the first and second reduction steps, comprising introducing the hydrogen until the pressure in the reduced pressure furnace is higher than atmospheric pressure; and
replacing, after the step of rapid cooling, the atmosphere of hydrogen inside the reduced pressure furnace with an atmosphere of nitrogen when the temperature therein becomes 60°C or below.

Bonding of a laminate, including at least two components to be bonded with a solder sheet therebetween, may thus be may be carried out in a short time by a soldering process which makes it possible to obtain a semiconductor device with few voids in the solder bonded layer. Moreover, solder bonding of the components to be bonded may be simultaneously carried out in the reduced pressure furnace, while voids in the solder are removed. Warping of the component to be bonded, induced by bonding different kinds of materials, is also quickly removed.

In the drawings:
Fig. 1 is a chart showing an example of temperature, atmosphere and pressure profiles in a chamber and a processing operation of the method according to the invention;
Fig. 2 is a schematic view showing the structure of a laminate to which soldering is carried out according to the invention;
Fig. 3 is a schematic view showing an arrangement inside a reduced pressure furnace in a bonding assembling apparatus used for carrying out the method according to the invention;
Fig. 4 is a view for explaining the principle of formation of a tunnel-like hole formed in solder as a trace of a travelled void;
Fig. 5 is a schematic view showing a uniform fillet shape after a second reduction process;
Fig. 6 is a schematic view showing an undesirable fillet shape before a second reduction process;
Fig. 7 is a characteristic diagram showing the relationship between grain size and the rate of creep of solder;
Fig. 8 is a SEM image of the metal structure of solder cooled at a cooling rate of 600°C per minute;
Fig. 9 is a SEM image of the metal structure of solder cooled at a cooling rate of 300°C per minute;
Fig. 10 is a SEM image of the metal structure of solder cooled at a cooling rate of 5°C per minute;
Fig. 11 is a SEM image of the metal structure of solder cooled at a cooling rate of 0.5°C per minute;
Fig. 12 is a schematic view showing the provision of solder on the bottom face of a silicon chip due to preliminary soldering;
Fig. 13 is a schematic view showing the process of soldering the silicon chip of Fig. 12 on to an insulator substrate through the solder provided on the bottom face of the silicon chip by preliminary soldering;
Fig. 14 is a cross-sectional view showing an example of an arrangement on the inside of the reduced pressure furnace used according to the method of the invention;
Fig. 15 is a characteristic diagram showing the thermal resistance distribution in a plurality of semiconductor devices manufactured by the method according to the invention;
Fig. 16 is a characteristic diagram showing a relationship between a the frequency of evacuation and a void fraction in a solder bonded layer according to the invention;
Fig. 17 is a characteristic diagram showing thermal resistance distribution in a plurality of semiconductor devices manufactured by a first conventional method;
Fig. 18 is an explanatory view showing an example for eliminating portions with non-uniform temperature in a hot plate and a cooling plate;
Fig. 19 is an explanatory view showing a further example for eliminating portions with non-uniform temperature in a hot plate and a cooling plate;
Fig. 20 is an explanatory view showing a further example for eliminating portions with non-uniform temperature in a hot plate and a cooling plate; and
Fig. 21 is an explanatory view showing a further example for eliminating portions with non-uniform temperature in a hot plate and a cooling plate.

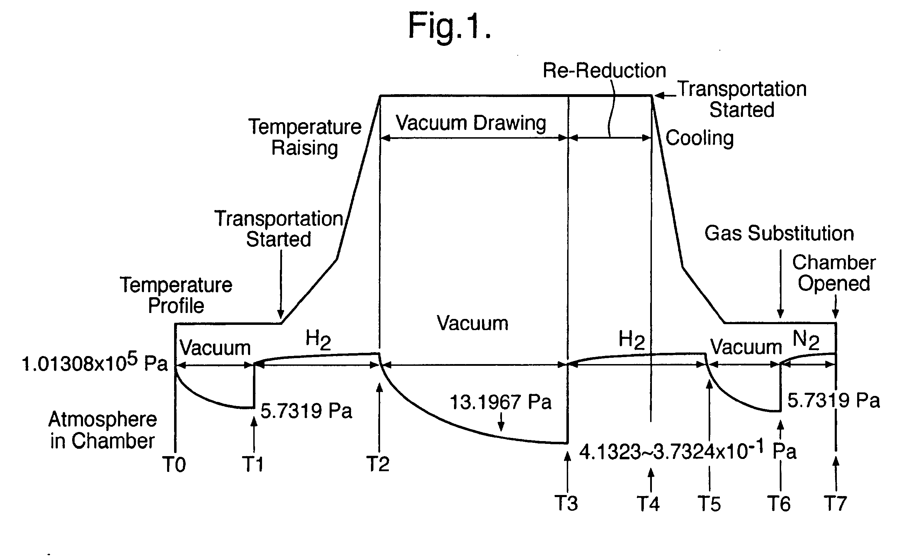

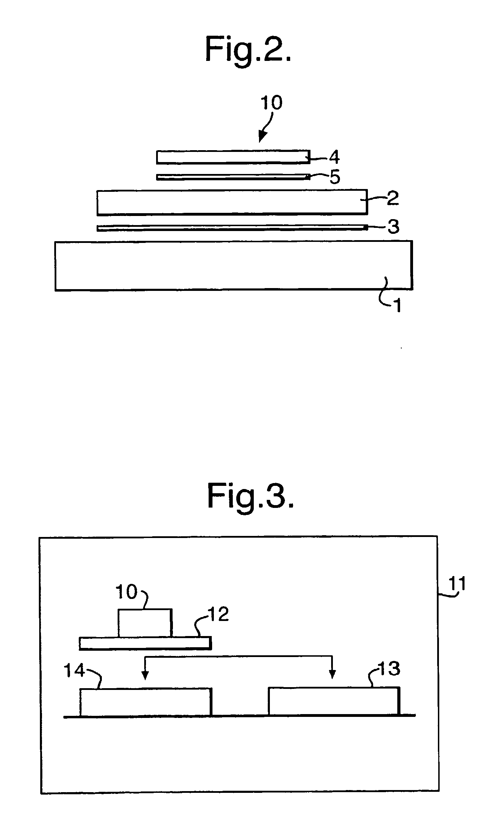

A method for carrying out the invention will now be explained in detail with reference to the drawings. Fig. 1 is a chart showing an example of temperature atmosphere and pressure profiles in a chamber and a processing operation in the method according to the invention. First, as a preparation and as shown in Fig. 2, an insulator substrate 2 is laminated on to a metal base 1, with a bonding solder sheet 3 placed between them. A silicon chip 4 is further laminated to this structure, with a bonding solder sheet 5 placed between the silicon chip and the insulator substrate. Such a laminate 10 is, as shown in Fig. 3, mounted on a transport stage 12 in a reduced pressure furnace 11. The transport stage 12 has a structure which can move back and forth between a hot plate 13 which heats the laminate 10, and a water cooling plate 14 for cooling the laminate 10.

When soldering begins according to the chart shown in Fig. 1, with the laminate 10 mounted on the transport stage 12, the reduced pressure furnace 11 is first sealed to start depressurization in the furnace (Fig. 1, timing T0). During this evacuation process, the transport stage 12 is in a "stand-by" state, that is, it is separated from both the hot plate 13 and the water cooling plate 14.

When it has been evacuated to a certain pressure, for example 5.7319Pa, hydrogen gas is introduced into the reduced pressure furnace 11 (Fig. 1, timing T1). The flow rate of the hydrogen gas is, for example, 10 litres per second. When the pressure in the reduced pressure furnace 11 becomes greater than atmospheric pressure, the transport stage 12 is transferred to the hot plate 13. This heats the laminate 10 until the temperature reaches a target bonding temperature.

In the above temperature raising process, (Fig. 1, timing T1 to T2), the pressure in the reduced pressure furnace 11, being higher than atmospheric pressure causes the hydrogen gas to penetrate into clearances between the respective components of the laminate 10. Therefore, oxidation reduction is activated on the surface of each of the insulator substrate and metal base bonding solder sheet 3, the silicon chip and insulator substrate bonding solder sheet 5, the insulator substrate 2 and the metal base 1. Thus, wettability of surfaces to be bonded, is ensured and wire bonding-capability is also ensured (first reduction processing). Moreover, each of the solder sheets 3 and 5 melts and the hydrogen gas fills voids produced at that time to thereby activate the voids. While the solder sheets 3 and 5 are melting, the oxygen concentration in the reduced pressure furnace 11 is kept at 30ppm or below, preferably at 10ppm or below, and the dew point is kept at -30°C or below, preferably at -50°C or below.

When the temperature reaches the target bonding temperature, depressurization inside the reduced pressure furnace 11 is started again (Fig. 1, timing T2). Then, after the reduced pressure furnace 11 has been evacuated to a certain degree, for example 13.1967Pa, depressurization is continued further, for one minute, for example. This reduces the pressure in the reduced pressure furnace 11 to approximately 4.1323 to 3.7324 x 10⁻¹Pa. The one minute continuation of the depressurization removes voids produced by insufficient wetting between the solder and the component to be bonded, along with voids produced by dissolved gas included in the solder material. Here, the reason for taking the continuation time as one minute is that no further void removing effect can be obtained, even if the depressurization is continued for longer than one minute.

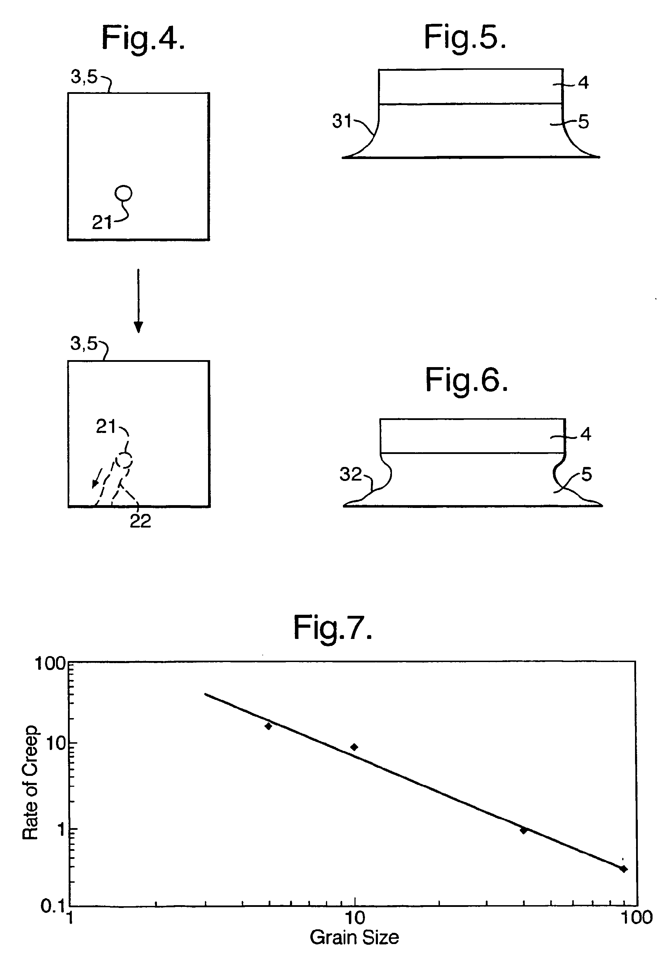

After this, hydrogen gas is introduced into the furnace again (Fig. 1, timing T3). After the pressure inside the reduced pressure furnace 11 becomes greater than atmospheric pressure, the hydrogen gas is continuously introduced for another one minute (a second reduction process). The reason for continuing the introduction of the hydrogen gas is to prevent a tunnel-like hole 22 (a trace of a travelled void 21), as shown in Fig. 4, from being created due to the reduction effect of hydrogen. The hole 22 remains in the solder sheet 3 or 5 when the void 21 is removed during the one minute continuation of the depressurization.

Namely, the void 21 in the solder sheet 3 or 5 is filled with gases of oxidizing components. A portion of the solder which comes into contact with the void 21 is therefore oxidized when the void 21 passes through it. This causes the wettability of the solder in the portion which the void 21 has passed through to decrease, and a tunnel-like void is left in the solder. Hydrogen gas filling the open void reduces the oxidized inner surface, which helps maintain the wettability of the solder surface.

Another reason for continuing to introduce hydrogen gas is to reduce the surface tension of the solder sheet 5, by continuing the reduction by hydrogen whilst heating the solder with the hot plate 13, thereby stabilizing a solder fillet shape 31 as shown in Fig. 5. This lengthens the solder life and decreases crack generation. As shown in Fig.6, if solidification of the solder sheet 5 by cooling is started soon after depressurization of the inside of the furnace without continuing to introduce hydrogen gas, a non-uniform solder fillet shape 32 results. This is due to the large surface tension of the solder sheet, and causes the solder life to be shortened due to the generation of cracks caused by thermal influences.

The surface tension of the solder sheet 5 can be reduced by continuing to heat the solder sheet 5, increasing the time for exposing the solder sheet 5 to hydrogen gas, or combining them. However, even if the introduction of hydrogen gas is continued for longer than one minute, not much difference is observed in the effect of filling the hole 22 of the trace of the passed void 21 or in the effect of stabilizing the solder fillet shape 31. Therefore, the time for which the introduction of hydrogen gas is continued is adequately taken as one minute.

On finishing the second reduction process, the transport stage 12 is transferred from the hot plate 13 to the water cooling plate 14, which begins to cool the laminate 10 down (Fig. 1, timing T4). The laminate 10 is cooled at a rate of, for example, 300°C per minute. When the temperature of the laminate 10 becomes, for example, 50 to 60°C, removal of the hydrogen gas in the reduced pressure furnace 11 begins (Fig. 1, timing T5).

When the pressure in the reduced pressure furnace 11 becomes, for example, 5.7319Pa due to the removal of hydrogen, nitrogen gas is introduced into the reduced pressure furnace 11 (Fig. 1, timing T6). After the nitrogen gas has been substituted into the reduced pressure furnace 11, and the hydrogen concentration in the furnace reaches the explosion limit or below, the reduced pressure furnace 11 is opened (Fig. 1, timing T7). The series of operations from timings T0 to T7 in Fig. 1 is completed within 15 minutes. By carrying these operations out, a semiconductor device which has a high quality solder bonded layer without any voids is obtained.

Here, the temperature of the hot plate 13 is preferably higher than the melting point of solder (by around 50°C). For example, in the case of using high Pb content solderwith a melting point of 301°C as the silicon chip and insulator substrate bonding solder sheet 5, and using Sn-Pb solder with a melting point of 183°C as the insulator substrate and metal base bonding solder sheet 3, the temperature of the hot plate 13 is taken as 350 to 360°C, with variations within the surface thereof taken into consideration.

Moreover, for example, in the case of using Sn-Ag group solderwith a melting point of 222°C as the silicon chip and insulator substrate bonding solder sheet 5, and using Sn-Pb solder with a liquid temperature of 234°C as the insulator substrate and metal base bonding solder sheet 3, the temperature of the hot plate 13 is 280 to 290°C according to the above explanation. However, considering that the effect of the reducing power of hydrogen is exhibited at 300°C or above, the temperature of the hot plate 13 is preferably taken as 300 to 310°C.

The result of experiments carried out by the inventors have also revealed that a combination of high Pb content solder (melting point: 301°C) and Sn-Pb solder (melting point: 183°C) caused the least numbers of voids in the solder bonded layer when the temperature of the hot plate 13 was at 350 to 360°C. Moreover, a combination of Sn-Ag group solder (melting point: 222°C) and Sn-Pb solder (melting point: 234°C) caused the least numbers of voids in the solder bonded layer when the temperature of the hot plate 13 was at 300 to 310°C.

When considering the cooling time the temperature of the water cooling plate 14, the rate of cooling (rate of solidification) of the solder must be taken into consideration. More specifically, in the processes described above, the silicon chip 4, the insulator substrate 2, and the metal base 1, which differ in their coefficients of thermal expansion, are simultaneously solder bonded. Once soldering is completed, this causes the metal base 1, which has the largest coefficient of thermal expansion, to warp out of shape so as to become convex toward the side of the insulator substrate 2. This influences the entire laminate 10 through the solder-bonded layers, to cause a maximum warping in the order of 0.3mm. If this deformation is present during the next wire bonding step, it can cause a failure in electrical characteristics as explained above. Therefore, it is necessary to remove the deformation before carrying out the wire bonding step.

In order to remove the deformation, the solder-bonded layer between the insulator substrate 2 and the metal base 1 can be subjected to a creep for a short time. Fig. 7 is a characteristic diagram showing a relationship between a grain size and a rate of creep of Sn-Pb solder (Sn-37Pb solder). It is known from the diagram that the rate of creep tends to increase as the diameter of the grain decreases. The tendency is the same in a solder material with a different ratio of composition of Sn and Pb. Therefore, by increasing the rate of creep, the metal structure (grain) can be made more fine.

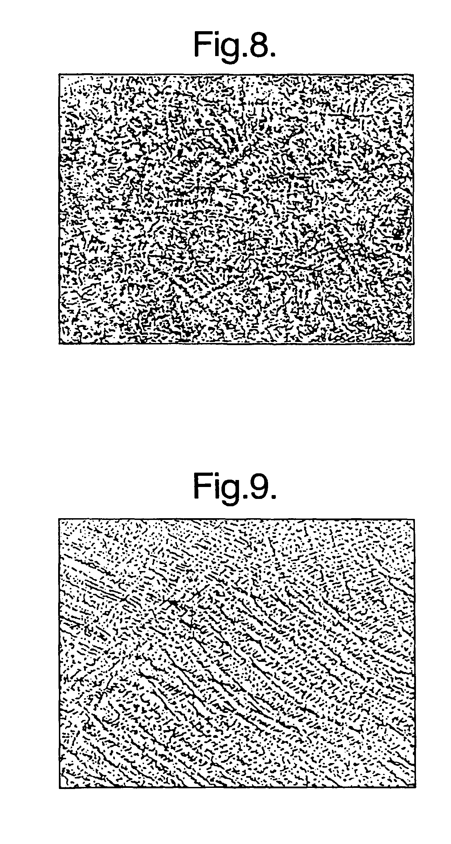

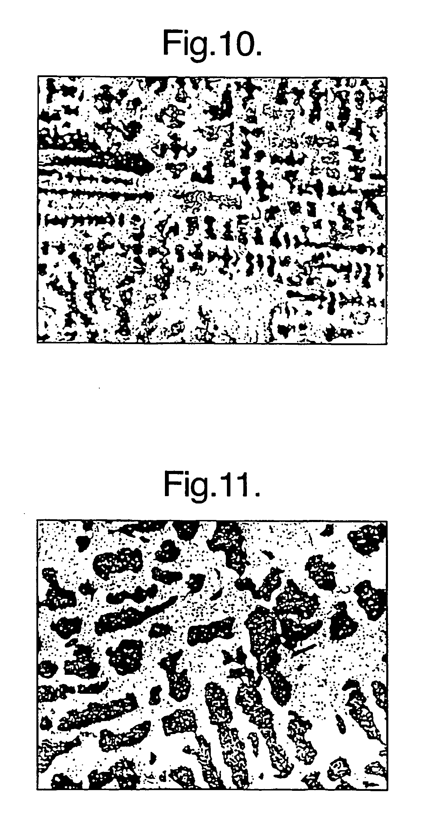

Figs. 8 and 11 show SEM images of metal structures of Sn-Pb solder (Sn-37Pb solder) when the cooling rate is changed. Figs. 8 to 11 are images for the cooling rates of 600°C per minute, 300°C per minute, 5°C per minute, and 0.5°C per minute, respectively. From these images, it can be seen that the solder structure becomes finer as the cooling rate increases. Therefore, from the relationships of rate of creep to grain size to cooling rate, it is known that the rate of creep can be increased by increasing the cooling rate (rate of solidification) of the solder. Therefore, the cooling rate is preferably taken as 250°C per minute or more, for example, as 300°C per minute.

Experiments carried out by the inventors revealed that the cooling rate of 250°C per minute or more causes the deformation of the metal base 1 to fall to within a range of 0 to -0.1mm (the sign "-" indicates that the warp is convex toward the side of the insulator substrate 2), which can eliminate an adverse effect on wire bonding. In other words, the cooling rate of 250°C per minute or less cannot sufficiently restore the warped metal base 1 so that the wire bonding is liable to be adversely affected. Moreover, by removing residual stress in the laminate 10 at the earliest possible stage after bonding with an increased creep rate, deformation of the metal base 1 can be stabilized. Therefore, the temperature and cooling time of the water cooling plate 14 are selected so that the cooling rate of the solder is 250°C per minute or more.

Additionally, when a silicon chip 4 has a size of 5mm square or less, the size of the solder sheet 5 is also 5mm square or less. Such considerably small sizes of the silicon chip and the solder sheet cause preliminary preparation of soldering to be time consuming, or cause insufficient positioning of the silicon chip 4 to the solder sheet 5, which can produce bonding failure.

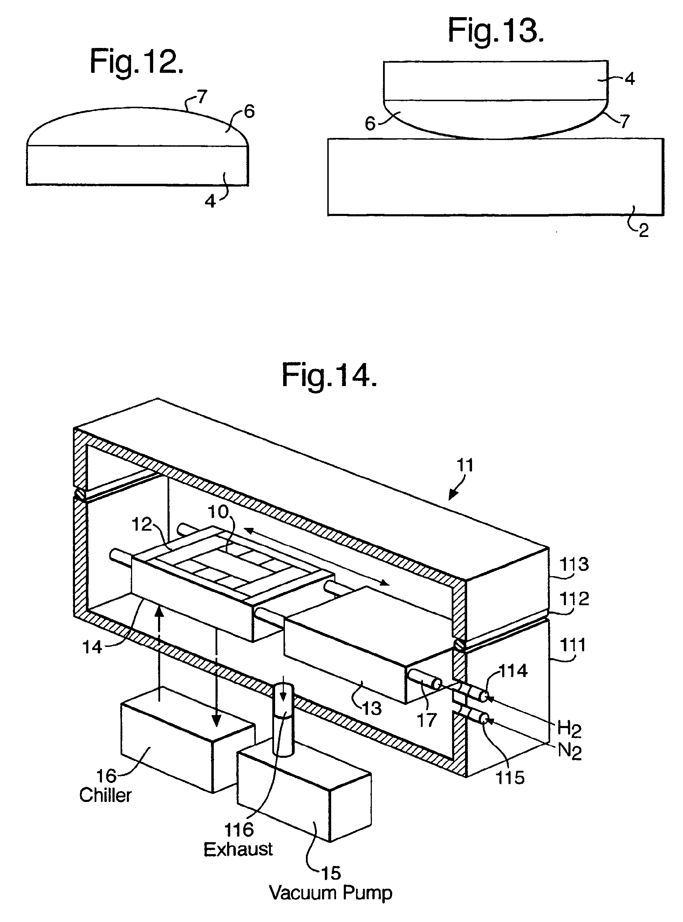

When carrying out solder bonding of the silicon chip 4 with such a size, therefore, it is desirable to carry out preliminary soldering by using the reduced pressure furnace 11 to provide silicon chip and insulator substrate bonding solder 6 beforehand on the bottom face (for example, a face of a collector electrode) of the silicon chip 4. When using solder having Sn, which is easily oxidised, as a principal component and containing no Pb, an atmosphere of very low oxygen concentration (several tens ppm or below) should be provided in the reduced pressure furnace 11. This will produce the least possible surface oxide film 7 on the solder 6 after preliminary soldering, as shown in Fig. 12. Then, as shown in Fig. 13, the silicon chip 4, the silicon chip 4 is soldered onto the insulator substrate 2 with the solder 6.

In addition, in a conventional method of manufacturing a power semiconductor device, when a silicon chip and an insulator substrate are soldered together and are then soldered onto a metal base, the oxygen concentration in a conventional continuous furnace is several thousands ppm. Therefore, in solder having Sn as a principal component and containing no Pb, preliminary soldering using the continuous furnace causes formation of a strong oxide film on the solder. Thus, it is impossible to obtain good solder bonding.

Fig. 14 is a cross sectional view showing an example of an arrangement inside a reduced pressure furnace. The reduced pressure furnace 11 includes a main body 111 and a lid 113 put thereon, with packing 112 held between them in order to keep the inside of the furnace gas tight. In the reduced pressure furnace 11, there are provided a hydrogen gas introducing pipe 114 for supplying hydrogen gas to the furnace, a nitrogen gas introducing pipe 115 for supplying nitrogen gas to the furnace, and an exhaust hole 116.

The hydrogen gas introducing pipe 114 is attached onto the rear side of the hot plate 13 in a spiral, spreading from the centre thereof toward outside. This is not shown in Fig. 14, however, in order to avoid complication of the figure. An arrangement is provided in which, from a plurality of holes provided on the spiral pipe, hydrogen gas heated by the hot plate 13 is uniformly blown off into the inside of the furnace. This enhances the reducing power. The hydrogen gas introducing pipe 114 and the nitrogen gas introducing pipe 115 are connected to a hydrogen gas supply source and a nitrogen gas supply source (not shown) respectively, outside the furnace. Moreover, a vacuum pump 15 is connected to the exhaust hole 116.

The water cooling plate 14 is connected to a chiller 16 on the outside of the furnace for circulating cooling water for the water cooling plate 14. Moreover, the transport stage 12 travels along transporting rails 17 between the hot plate 13 and the water cooling plate 14.

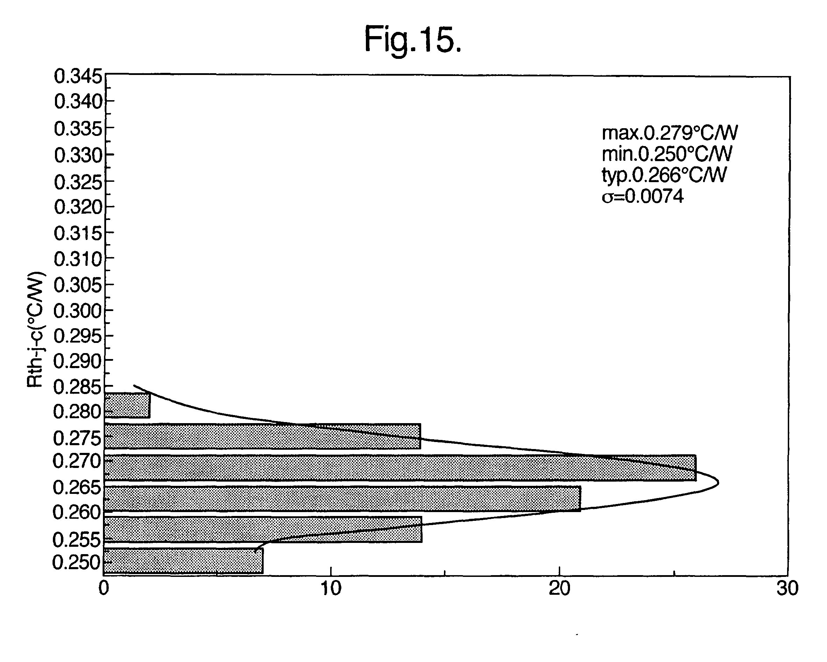

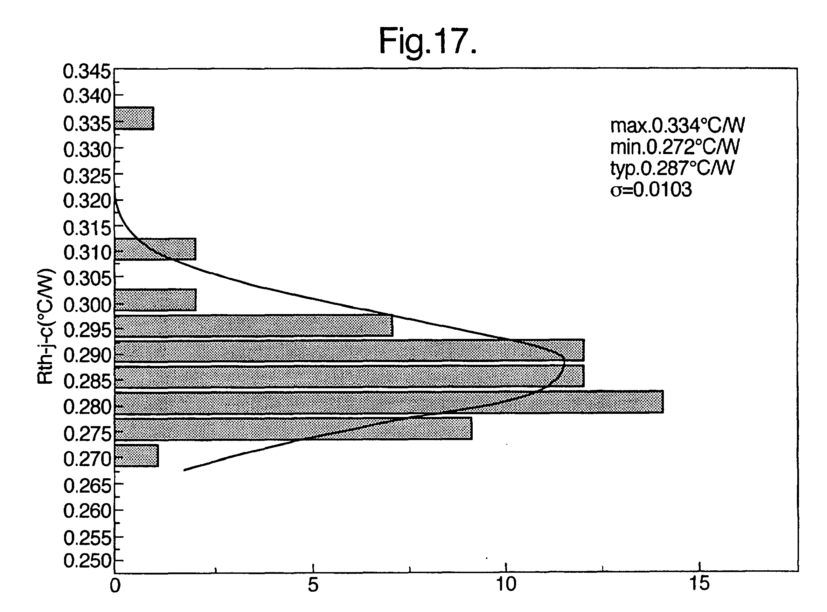

Fig. 15 shows an example of the thermal resistance distribution in a plurality of semiconductor devices manufactured by a method according to the invention. For comparison, Fig. 17 shows an example of the thermal resistance distribution in a plurality of semiconductor devices manufactured by the first method of the above-explained prior art. As is apparent from Fig. 15, according to the method described above, an averaged value, the maximum value, and the minimum value of the thermal resistance distribution are 0.266°C/W, 0.279°C/W, and 0.250°C/W, respectively. In addition, the standard deviation is 0.0074.

Compared with this, in the conventional first method, the averaged value, the maximum value, the minimum value, and the standard deviation of the thermal resistance distribution are 0.287°C/W, 0.334°C/W, and 0.272°C/W, and 0.0103, respectively. By comparison of the two, it can be seen that values of the thermal resistance and the deviation thereof are apparently smaller in the method according to the present invention. Namely, it was ascertained that a void fraction in a solder bonded layer and the deviation thereof can be made smaller by the method according to the invention than those in the conventional method, thereby enhancing the heat dissipation of the semiconductor device.

According to the method described above, the solder sheet 3, the insulator substrate 2, the solder sheet 5, and the silicon chip 4 are laminated, in that order, on the metal base 1. The laminate 10 is fed into the bonding assembling apparatus provided with a reduced pressure furnace 11. After evacuating the inside of the furnace, a surface of each of the components included in the laminate 10 is reduced by introducing hydrogen into the furnace 11 until the pressure inside the furnace 11 is greater than atmospheric pressure. After the solder is heated and melted, the voids in the solder sheets 3 and 5 are removed by evacuating until it contains a vacuum the furnace again. Subsequent to this, hydrogen is re-introduced until the pressure in the furnace 11 is again greater than atmospheric pressure, to prevent production of tunnel-like holes 22 in the solder sheets 3 and 5, caused by travelled voids 21. Additionally, the solder fillet shape 31 is made uniform. The laminate 10 is then rapidly cooled to make the solder structure finer. This increases the rate of creep of the solder served for bonding the insulator substrate 2 and the metal base 1 to quickly eliminate warping of the metal base 1, caused by differences in the coefficients of thermal expansion, and return it to its original state. Therefore, approximately ten minutes after starting the operation of the reduced pressure furnace 11, a semiconductor device having a solder bonded layer with higher quality and reliability, which is also more efficient in heat dissipation than a conventional one, can be produced.

Moreover, according to the present invention, compared with prior art, less hydrogen gas and nitrogen gas are required, and there is no need to use flux. Therefore, operational costs are reduced and the environment is not adversely affected.

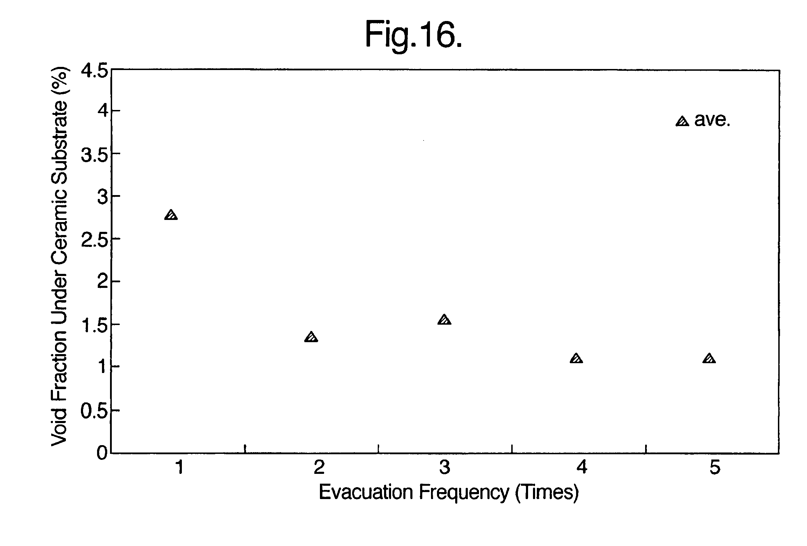

In the foregoing description, the invention is not limited to the method described above, but can be modified. For example, the evacuation steps between the timings T2 and T3 in Fig. 1 are normally carried out once. When a large area substrate is bonded, however, or when the voids cannot easily be removed, the evacuation step can be repeated a plurality of times. Depressurization and pressurization repeated in this way cause shaking in the melting solder which eases the removal of the voids. Fig. 16, shows the relationship between the frequency of evacuation and the void fraction in the solder bonded layer where the evacuation is repeated up to five times. The void fraction becomes small as the frequency is increased, however after five repetitions no further affect is obtained by a further increase in frequency.

Furthermore, in an assembling apparatus including a reduced pressure furnace a hot plate provided with a heater for melting solder, a water cooling plate provided with a cooling water circulating path for fixing the solder, and a transport stage for melting and solidifying the solder, the hot plate and the cooling plate are disposed in close proximity to each other in the reduced pressure furnace. Therefore, the temperature of the portion of the hot plate adjacent to the cooling plate decreases. Meanwhile, the temperature of the portion of the cooling plate adjacent to the hot plate increases.

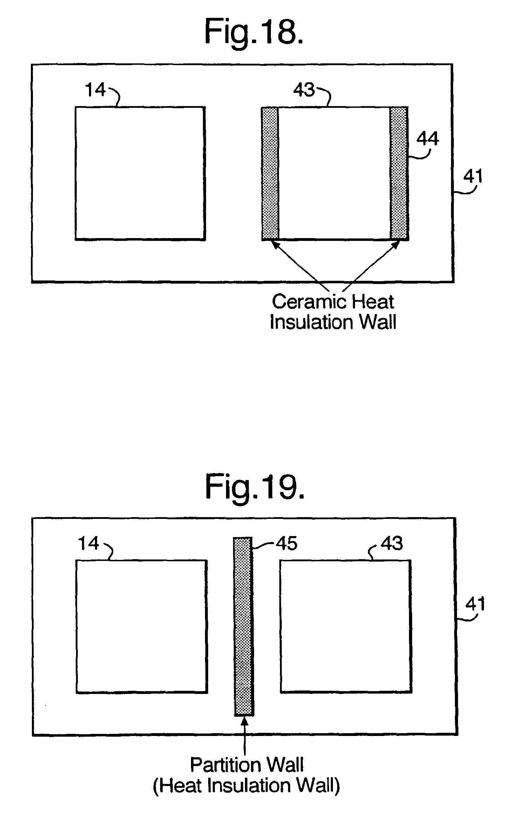

Examples of ways of eliminating these portion with such non-uniform temperature are shown in Figs. 18 to 21. In Fig. 18, thermal insulation is provided by ceramic walls 44 on the outer periphery of a hot plate 43 in the reduced pressure furnace, in order to prevent thermal interference. In Fig. 19, a partition wall 45 is provided between the hot plate 43 and the cooling plate 14 to prevent thermal interference. In this case iron group materials and ceramic materials may be used to construct the partition wall 45.

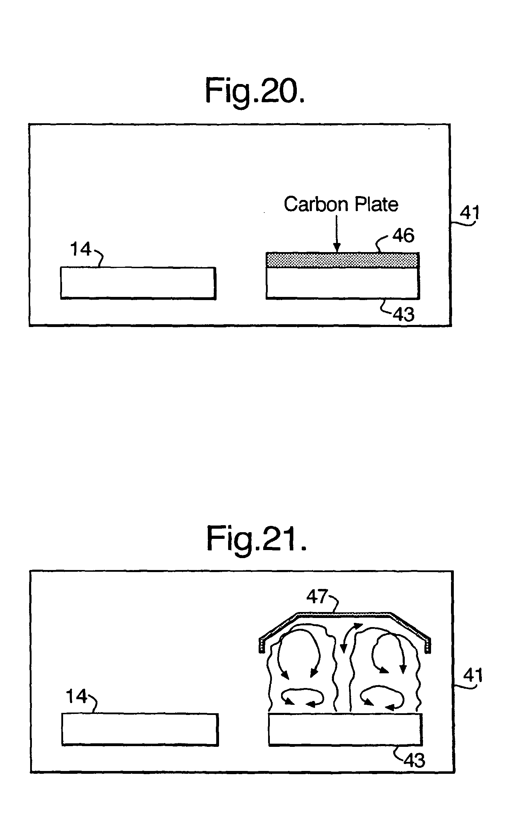

In Fig. 20, a carbon plate 46 which has a thickness of 2 to 3mm is laid on the hot plate 43. The carbon plate 46, which is made of a material which heats up easily but is difficult to cool, retains the heat so as to maintain the uniform temperature of the hot plate, and therefore no heat can be transferred to the cooling plate14. In Fig. 21, a heat shield plate 47 is provided above the hot plate 43, thereby keeping active hydrogen near the hot plate 43. This causes the arrangement to exhibit a hydrogen activation effect at soldering, and results in heat insulation by hydrogen gas around the hot plate 43.

According to the invention, solder bonding of a metal base and an insulator substrate and solder bonding of the insulator substrate and a silicon chip are simultaneously performed. Meanwhile, voids in the solder are removed and warping of the metal base caused by the bonding of different kinds of materials is quickly removed. Therefore, within ten minutes from beginning the operation of a reduced pressure furnace, a semiconductor device can be obtained which has solder bonded layers of higher quality and reliability and which dissipates heat more efficiently than conventional ones. Additionally, operational costs are reduced and adverse effects on the environment are prevented by the method according to the invention.

## Claims

1. A method of manufacturing a semiconductor device comprising the steps of:
feeding a laminate (10) into a reduced pressure furnace (11), the laminate including at least two components (1, 2, 4) to be bonded with a solder sheet (3, 5) therebetween;
evacuating the inside of the reduced pressure furnace in a depressurisation step;
in a first reduction step, introducing hydrogen into the reduced pressure furnace and then heating the inside of the reduced pressure furnace to a bonding temperature to melt the solder sheet while maintaining the composition and pressure of the atmosphere therein;
in a void removing step, removing the voids (21) in the liquefied solder by evacuating the reduced pressure furnace, while keeping the temperature therein at the bonding temperature;
in a second reduction step, introducing hydrogen into the reduced pressure furnace while keeping the temperature therein at the bonding temperature, and then maintaining the pressure and temperature for a specified length of time; and
rapidly cooling the laminate while maintaining the composition and pressure of the atmosphere inside the reduced pressure furnace,
**characterised in that**
the step of introducing hydrogen into the reduced pressure furnace, in both the first and second reduction steps, comprises introducing the hydrogen until the pressure in the reduced pressure furnace is higher than atmospheric pressure; and it further comprises
replacing, after the step of rapid cooling, the atmosphere of hydrogen inside the reduced pressure furnace with an atmosphere of nitrogen when the temperature therein becomes 60°C or below.

2. A method of manufacturing a semiconductor device according to claim 1, further comprising the steps of:
making the solder structure finer to increase the rate of creep during cooling in order to remove warping of the components (1, 2, 4) to be bonded due to differences in coefficients of thermal expansion among the components;
between the step of rapidly cooling the laminate and the step of replacing the atmosphere of hydrogen inside the reduced pressure furnace with an atmosphere of nitrogen, evacuating the reduced pressure furnace (11) in a further depressurisation step.

3. A method of manufacturing a semiconductor device according to claim 1 or claim 2, wherein the rapid cooling is carried out at a rate of 250°C per minute or more.

4. A method of manufacturing a semiconductor device according to claim 3, wherein the rapid cooling is carried out at a rate of 300°C per minute or more.

5. A method of manufacturing a semiconductor device according to any of the preceding claims, further comprising, between said void removing step and said second reduction step, and while keeping the temperature in the reduced pressure furnace at the bonding temperature:
(a) introducing hydrogen into the reduced pressure furnace (11) until the pressure in the reduced pressure furnace is higher than atmospheric pressure; and
(b) repeating said void removing step; and
(c) repeating steps (a) and (b) between 0 and 4 times.

6. A method of manufacturing a semiconductor device according to any of the preceding claims, wherein the hydrogen gas is heated by a heating plate (13, 43) heating the laminate (10) on the inside of the reduced pressure furnace (11), the hydrogen gas being uniformly supplied over the heating plate.

7. A method of manufacturing a semiconductor device according to any of the preceding claims, wherein, during melting of the solder sheet (3, 5), the oxygen concentration inside the reduced pressure furnace (11) is kept at 30ppm or below, and wherein the dew point thereof is kept at -30°C or below.

8. A method of manufacturing a semiconductor device according to any of the preceding claims, wherein the oxygen concentration inside the reduced pressure furnace (11) is kept at 10ppm or below, and wherein the dew point thereof is kept at -50°C or below.

## Patentansprüche

1. Verfahren zum Herstellen einer Halbleitervorrichtung, das die folgenden Schritte umfasst:
Einleiten eines Laminats (10) in einen Unterdruckofen (11), wobei das Laminat wenigstens zwei Komponenten (1, 2, 4) enthält, die mit einem Lotblech (3, 5) dazwischen zu verbinden sind;
Evakuieren des innenraums des Unterdruckofens in einem Druckreduzierungsschritt;
in einem ersten Reduktionsschritt Einleiten von Wasserstoff in den Unterdruckofen und anschließendes Erwärmen des Innenraums des Unterdruckofens auf eine Verbindungstemperatur, um das Lotblech zum Schmelzen zu bringen, und gleichzeitig Aufrechterhalten der Zusammensetzung und des Drucks der Atmosphäre darin;
in einem Hohlraum-Entfernungsschritt Entfernen der Hohlräume (21) in dem verflüssigten Lot durch Evakuieren des Unterdruckofens, wobei gleichzeitig die Temperatur darin auf der Verbindungstemperatur gehalten wird;
in einem zweiten Reduktionsschritt Einleiten von Wasserstoff in den Unterdruckofen, wobei gleichzeitig die Temperatur darin auf der Verbindungstemperatur gehalten wird, und anschließend Halten des Drucks und der Temperatur über einen vorgegebenen Zeitraum; und
schnelles Abkühlen des Laminats, wobei gleichzeitig die Zusammensetzung und der Druck der Atmosphäre im Inneren des Unterdruckofens aufrechterhalten werden,
**dadurch gekennzeichnet, dass**
der Schritt des Einleitens von Wasserstoff in den Unterdruckofen sowohl im ersten als auch im zweiten Reduktionsschritt umfasst, dass der Wasserstoff eingeleitet wird, bis der Druck in dem Unterdruckofen höher ist als atmosphärischer Druck; und
Austauschen der Wasserstoffatmosphäre im Inneren des Unterdruckofens gegen eine Stickstoffatmosphäre nach dem Schritt des schnellen Abkühlens, wenn die Temperatur darin 60°C oder niedriger wird.

2. Verfahren zum Herstellen einer Halbleitervorrichtung nach Anspruch 1, das des Weiteren die folgenden Schritte umfasst:
Verfeinern der Lotstruktur, um die Kriechrate beim Abkühlen zu erhöhen und Verziehen der zu verbindenden Komponenten (1, 2, 4) aufgrund von Unterschieden des Wärmeausdehnungskoeffizienten zwischen den Komponenten aufzuheben;
zwischen dem Schritt des schnellen Abkühlens des Laminats und dem Schritt des Austauschens der Wasserstoffatmosphäre im Inneren des Unterdruckofens gegen eine Stickstoffatmosphäre, Evakuieren des Unterdruckofens (11) in einem weiteren Druckreduzierungsschritt.

3. Verfahren zum Herstellen einer Halbleitervorrichtung nach Anspruch 1 oder 2, wobei das schnelle Abkühlen mit einer Rate von 250°C pro Minute oder mehr ausgeführt wird.

4. Verfahren zum Herstellen einer Halbleitervorrichtung nach Anspruch 3, wobei das schnelle Abkühlen mit einer Rate von 300°C pro Minute oder mehr ausgeführt wird.

5. Verfahren zum Herstellen einer Halbleitervorrichtung nach einem der vorangehenden Ansprüche, das des Weiteren zwischen dem Schritt des Entfernens von Hohlräumen und dem zweiten Reduktionsschritt bei gleichzeitigem Halten der Temperatur in dem Unterdruckofen auf der Verbindungstemperatur umfasst:
(a) Einleiten von Wasserstoff in den Unterdruckofen (11), bis der Druck in dem Unterdruckofen höher ist als atmosphärischer Druck; und
(b) Wiederholen des Hohlraum-Entfernungsschritts; und
(c) Wiederholen der Schritte (a) und (b) zwischen 0- und 4-mal.

6. Verfahren zum Herstellen einer Halbleitervorrichtung nach einem der vorangehenden Ansprüche, wobei das Wasserstoffgas mit einer Heizplatte (13, 43) erhitzt wird, die das Laminat (10) im Innenraum des Unterdruckofens (11) erhitzt, und das Wasserstoffgas gleichmäßig über die Heizplatte zugeführt wird.

7. Verfahren zum Herstellen einer Halbleitervorrichtung nach einem der vorangehenden Ansprüche, wobei während des Schmelzens der Lotplatte (3, 5) die Sauerstoffkonzentration im Innenraum des Unterdruckofens (11) auf 30 ppm oder darunter gehalten wird und der Taupunkt desselben auf -30°C oder darunter gehalten wird.

8. Verfahren zum Herstellen einer Halbleitervorrichtung nach einem der vorangehenden Ansprüche, wobei die Sauerstoffkonzentration im Innenraum des Unterdruckofens (11) auf 10 ppm oder darunter gehalten wird und der Taupunkt desselben auf -50°C oder darunter gehalten wird.

## Revendications

1. Procédé de préparation d'un dispositif semiconducteur, comprenant les étapes de :
alimentation d'un stratifié (10) dans un four à pression réduite (11), le stratifié comprenant au moins deux composants (1, 2, 4) à relier avec une feuille de soudage (3, 5) entre eux ;
évacuation de l'intérieur du four sous pression réduite au cours d'une étape de dépressurisation ;
dans une première étape de réduction, introduction d'hydrogène dans le four à pression réduite et chauffage de l'intérieur du four à pression réduite jusqu'à une température de liaison pour faire fondre la feuille de soudage tout en y maintenant la composition et la pression de l'atmosphère ;
dans une étape d'élimination des vides, élimination des vides (21) dans le soudage liquéfié par évacuation du four à pression réduite, tout en maintenant la température à la température de liaison ;
dans une deuxième étape de réduction, introduction d'hydrogène dans le four à pression réduite tout en maintenant la température dans celui-ci à la température de liaison pendant une période spécifiée ; et
refroidissement rapide du stratifié tout en maintenant la composition et la pression de l'atmosphère à l'intérieur du four à pression réduite,
**caractérisé en ce que** l'étape d'introduction d'hydrogène dans le four à pression réduite, dans les première et deuxième étapes de réduction, comprend l'introduction de l'hydrogène jusqu'à ce que la pression dans le four à pression réduite soit supérieure à la pression atmosphérique, et
il comprend en outre, le remplacement, après l'étape de refroidissement rapide, de l'atmosphère à l'intérieur du four à pression réduite par une atmosphère d'azote lorsque la température est de 60°C ou moins.

2. Procédé de préparation d'un dispositif semiconducteur selon la revendication 1, comprenant en outre, les étapes de :
préparation d'une structure de soudage plus fine pour augmenter la vitesse de fluage pendant le refroidissement afin d'éliminer le gauchissement des composants (1, 2, 4) à relier à cause des différences de coefficient de dilatation thermique entre les composants ;
entre l'étape de refroidissement rapide du stratifié et l'étape de remplacement de l'atmosphère d'hydrogène dans le four à pression réduite par une atmosphère d'azote, évacuation du four à pression réduite (11) au cours d'une autre étape de dépressurisation.

3. Procédé de préparation d'un dispositif semiconducteur selon la revendication 1 ou 2, où le refroidissement rapide est réalisé à une vitesse de 250°C par minute ou plus.

4. Procédé de préparation d'un dispositif semiconducteur selon la revendication 3, dans lequel le refroidissement rapide est réalisé à une vitesse de 300°C par minute ou plus.

5. Procédé de préparation d'un dispositif semiconducteur selon l'une quelconque des revendications précédentes, comprenant en outre, entre ladite étape d'élimination des vides et ladite deuxième étape de réduction, et tout en maintenant la température dans le four à pression réduite à la température de liaison:
(a) l'introduction d'hydrogène dans le four à pression réduite (11) jusqu'à ce que la pression dans le four à pression réduite soit supérieure à la pression atmosphérique, et
(b) la répétition de ladite étape d'élimination des vides, et
(c) la répétition des étapes (a) et (b) de 0 à 4 fois.

6. Procédé de préparation d'un dispositif semiconducteur selon l'une quelconque des revendications précédentes, dans lequel l'hydrogène est chauffé par une plaque chauffante (13, 43), chauffant le stratifié (10) à l'intérieur du four à pression réduite (11), l'hydrogène étant fourni uniformément sur la plaque chauffante.

7. Procédé de préparation d'un dispositif semiconducteur selon l'une quelconque des revendications précédentes, dans lequel, pendant la fusion de la feuille de soudage (3, 5), la concentration en oxygène dans le four à pression réduite (11) est maintenue à 30 ppm ou moins, et où le point de rosée est maintenu à -30°C ou moins.

8. Procédé de préparation d'un dispositif semiconducteur selon l'une quelconque des revendications précédentes, dans lequel, la concentration en oxygène dans le four à pression réduite (11) est maintenue à 10 ppm ou moins, et où le point de rosée est maintenu à - 50°C ou moins.
